# EUROPÄISCHE PATENTSCHRIFT

(11) **EP 3 111 735 B1**
(45) Veröffentlichungstag und Bekanntmachung des Hinweises auf die Patenterteilung: **22.05.2019**
(21) Anmeldenummer: 15708464.1
(22) Anmeldetag: 25.02.2015
(51) Int. Cl.: H05K 3/46, H05K 3/04, H05K 3/40

(54) **FOLIENVERBUND MIT ELEKTRISCHER FUNKTIONALITÄT ZUM AUFBRINGEN AUF EIN SUBSTRAT**
LAMINATE WITH ELECTRICAL FUNCTIONALITY TO BE APPLIED ONTO A SUBSTRATE
LAMINÉ AVEC FONCTION ÉLECTRIQUE À APPLIQUER SUR UN SUBSTRAT

(30) Priorität: 26.02.2014 DE 102014102519
(43) Veröffentlichungstag der Anmeldung: 04.01.2017
(73) Patentinhaber: Schreiner Group GmbH & Co. KG, 85764 Oberschleissheim (DE)
(72) Erfinder: FISCHER, Wolfram, 86356 Neusäß (DE); NITSCHKE, Olaf, 81371 München (DE); SAMUEL, Thomas, 80933 München (DE); WIESENER, Oliver, 80799 München (DE)
(74) Vertreter: Epping - Hermann - Fischer
(86) Internationale Anmeldenummer: PCT/EP2015/053935
(87) Internationale Veröffentlichungsnummer: WO 2015/128378

(56) Entgegenhaltungen:
- EP-A2- 2 081 204
- DE-A1-102007 055 275
- GB-A- 2 203 905
- US-A1- 2007 283 997

## Beschreibung

Die Erfindung betrifft einen Folienverbund mit elektrischer Funktionalität zum Aufbringen auf ein Substrat. Die Erfindung betrifft des Weiteren ein Verfahren zum Herstellen eines derartigen Folienverbundes.

Beispielsweise können zur Verbindung von Bauelementen elektrischer beziehungsweise elektronischer Schaltungen, auf einer Schaltungsplatine gedruckte oder geätzte Leiterbahnen angeordnet sein. Eine weitere Möglichkeit besteht darin, die elektronischen Bauelemente über Kabel beziehungsweise Drähte miteinander zu verbinden. Über die Leiterbahnen, Kabel oder Drähte können elektrische Signale übertragen oder eine Spannungsversorgung zum Betreiben der Bauelemente zur Verfügung gestellt werden.

Die Herstellung von gedruckten oder geätzten leitfähigen Strukturen ist insbesondere durch teure Leitpasten oder in Folge des Ätzens der leitfähigen Strukturen durch Ätzbäder mit hohen Kosten und einem hohen Herstellungsaufwand verbunden. Aufgrund hoher Vorlaufkosten für die notwendigen Masken, beispielsweise für Druck- oder Ätzmasken, lohnt sich die Herstellung von leitfähigen Strukturen mittels Druck- oder Ätztechnik nur bei entsprechend hoher Stückzahl. Neben dem hohen Herstellungsaufwand und den damit verbundenen teuren Kosten weisen leitfähige Strukturen auf Basis gedruckter/geätzter Leiterbahnen beziehungsweise auf Basis von Kabeln oder Drähten oftmals nur eine eingeschränkte Funktionalität auf. Insbesondere bei Druckleitpasten tritt beispielsweise ein hoher elektrischer Widerstand auf. Auf eine Platine aufgedampfte leitfähige Strukturen weisen aufgrund der dünnen Leiterbahndicke ebenfalls einen hohen elektrischen Widerstand und eine geringe mechanische Stabilität auf. Zudem ist bedingt durch die dünnen Strukturen in vielen Fällen kein Löten möglich. Unter Umweltgesichtspunkten ist die Herstellung insbesondere von geätzten leitfähigen Strukturen kritisch, da durch die Verwendung von hoch aggressiven Ätzlösungen eine hohe Umweltbelastung auftritt.

Die Verwendung von gedruckten oder geätzten leitfähigen Strukturen auf einer Platine führt für das Schaltungsdesign zu einer eingeschränkten Flexibilität, da es sich um einen fest gefügten Verbund zwischen der elektrisch leitenden Struktur und einem Träger handelt

Weitere Einschränkungen bestehen bezüglich der Materialien einer Trägerbahn, auf der die leitfähige Struktur aufgebracht wird. Als Trägermaterial wird meist Polyimid verwendet, so dass keine Transparenz gegeben ist, was, insbesondere beim Aufbringen der leitfähigen Struktur in einer Umgebung einer Lichtquelle jedoch oftmals von Interesse ist.

Bisher für leitfähige Strukturen verwendete Blechstanzteile sind typischerweise als Schüttgut erzeugt oder sind innerhalb eines Stützgitters eingebunden, was wiederum mit funktionellen Einschränkungen verbunden ist oder zumindest Nachteile in der Verarbeitung mit sich bringt.

Die GB 2 203 905 A betrifft eine flexible Schaltung mit einem nichtleitfähigen Substrat, auf dem eine leitfähige Schicht in Form von Leiterbahnen aufgebracht ist. In der US 2007/283997 A1 ist ein Fotovoltaikmodul mit einem auf einer Trägerschicht angeordneten flexiblen Leiter, der zwischen zwei Fotovoltaikzellen angeordnet ist, beschrieben.

Es ist ein Anliegen der vorliegenden Erfindung einen Folienverbund mit elektrischer Funktionalität bereitzustellen, der auf einfache und flexible Weise auf ein Substrat aufgebracht werden kann. Des Weiteren soll ein Verfahren zum Herstellen eines derartigen Folienverbundes mit elektrischer Funktionalität, der auf einfache und flexible Weise auf ein Substrat aufgebracht werden kann, angegeben werden.

Ein derartiger Folienverbund ist im Patentanspruch 1 angegeben. Gemäß einer Ausführungsform umfasst der Folienverbund mit elektrischer Funktionalität zum Aufbringen auf ein Substrat mindestens eine leitfähige Struktur, eine erste Verbindungsschicht, eine Folienlage und eine zweite Verbindungsschicht. Die erste Verbindungsschicht kann an einer Unterseite der mindestens einen leitfähigen Struktur angeordnet sein. Die erste Verbindungsschicht kann eine Haftwirkung zum Aufbringen der mindestens einen leitfähigen Struktur auf dem Substrat aufweisen. Die zweite Verbindungsschicht kann zwischen einer Oberseite der mindestens einen leitfähigen Struktur und der Folienlage angeordnet sein.

Die zweite Verbindungsschicht kann eine Haftwirkung, durch die die Folienlage an der mindestens einen leitfähigen Struktur haftet, aufweisen.

Der Folienverbund kann eine Trägerfolie aufweisen, auf der die mindestens eine leitfähige Struktur und die darüber angeordnete Folienlage angeordnet sind. Die Folienlage kann sich über die mindestens eine leitfähige Struktur hinaus erstrecken und durch die zweite Verbindungsschicht an der Trägerfolie haften, so dass die Folienlage als eine Abdeckfolie zum Schutz der mindestens einen leitfähigen Struktur dient.

Der Folienverbund kann auf einfache und flexible Weise auf einem Substrat, zum Beispiel auf einer Schaltungsplatine, auf einer Bedienblende oder auf Gehäuseteilen angeordnet werden. Dazu wird der Folienverbund aus der mindestens einen leitfähigen Struktur und der darüber angeordneten Folienlage von der Trägerfolie abgezogen und mit der ersten und zweiten Verbindungsschicht auf das Substrat aufgebracht, beispielsweise aufgeklebt oder eingespritzt. Der erfindungsgemäße Folienverbund ermöglicht die Transferierbarkeit der leitfähigen Struktur auf beliebige andere Substrate.

Die Trägerfolie kann derart ausgestanzt sein, dass der ausgestanzte Teil der Trägerfolie an zumindest einem Teilbereich der mindestens einen leitfähigen Struktur haftet, so dass der Bereich der ersten Verbindungsschicht, der unter der mindestens einen leitfähigen Struktur angeordnet ist, von der Trägerfolie abgedeckt bleibt, wenn der Folienaufbau aus der ersten Verbindungsschicht, dem darunter haftenden ausgestanzten Teil der Trägerfolie, der mindestens einen leitfähigen Struktur, der zweiten Verbindungsschicht und der Folienlage von der restlichen Trägerfolie abgenommen wird. Beim Applizieren auf ein Substrat haftet die mindestens eine leitfähige Struktur in diesem Teilbereich nicht unmittelbar auf dem Substrat. Dadurch können in der leitfähigen Struktur Bereiche bereitgestellt werden, welche nicht kleben, sondern durch einen Abschnitt der Trägerfolie geschützt sind.

Gemäß einer möglichen Ausführungsform kann die mindestens eine leitfähige Struktur anstatt unmittelbar auf der Trägerfolie zu haften unmittelbar auf eine weitere Folienlage aufgebracht sein. Die mindestens eine leitfähige Struktur kann mittels der ersten Verbindungsschicht auf der weiteren Folienlage haften. Der Folienverbund kann eine dritte Verbindungsschicht, die zwischen der weiteren Folienlage und der Trägerfolie angeordnet ist, aufweisen. Die dritte Folienlage kann mittels der an ihrer Unterseite angeordneten dritten Verbindungsschicht zusammen mit der über ihr angeordneten mindestens einen leitfähigen Struktur und der Folienlage auf die Trägerfolie aufgeklebt sein. Bei dieser Ausführungsform ist die mindestens eine leitfähige Struktur zwischen der Folienlage und der weiteren Folienlage eingebettet.

Bei der Ausführungsform kann der Folienaufbaus aus der weiteren Folienlage, der darüber angeordneten mindestens einen leitfähigen Struktur, der Folienlage und der erste, zweiten und dritten Verbindungsschicht bei der Applikation von der Trägerfolie abgezogen und mittels der dritten Verbindungsschicht auf ein Substrat aufgeklebt werden.

Ein Teil der Trägerfolie kann auch bei dieser Ausführungsform aus der übrigen Trägerfolie ausgestanzt sein und an der dritten Verbindungsschicht haften. Somit haftet der ausgestanzte Teil der Trägerfolie auch nach dem Abziehen des Folienaufbaus aus der weiteren Folienlage, der mindestens eine leitfähige Struktur und der Folienlage von der restlichen Trägerfolie an der dritten Verbindungsschicht. Beim Applizieren des Folienaufbaus auf ein Substrat, beispielsweise eine Schaltungsplatine, ist der ausgestanzte Teil der Trägerfolie somit zwischen der dritten Verbindungsschicht und dem Substrat angeordnet. Die weitere Folienlage haftete an den nicht abgedeckten Abschnitten mittels der dritten Verbindungsschicht auf dem Substrat.

Ein Verfahren zum Herstellen eines Folienverbundes mit elektrischer Funktionalität ist im Patentanspruch 10 angegeben. Gemäß einer Ausführungsform des Verfahrens wird zunächst eine Trägerfolie bereitgestellt. Eine elektrisch leitfähige Folie wird auf der Trägerfolie angeordnet. Zur Erzeugung der mindestens einen leitfähigen Struktur in der elektrisch leitfähigen Folie wird mindestens eine erste Schnittlinie in einen Bereich der elektrisch leitfähigen Folie derart eingebracht, dass die elektrisch leitfähige Folie durch die mindestens eine erste Schnittlinie an dem Bereich der elektrisch leitfähigen Folie durchtrennt wird und ein erster unter dem Bereich der elektrisch leitfähigen Folie angeordneter Bereich der Trägerfolie unversehrt bleibt, wodurch mindestens eine leitfähige Struktur in der elektrisch leitfähigen Folie gebildet wird, die durch die mindestens eine Schnittlinie von einem restlichen Teil der elektrisch leitfähigen Folie getrennt ist. Zur Bereitstellung der mindestens einen leitfähigen Struktur wird der restliche Teil der elektrisch leitfähigen Folie entfernt. Auf einer Oberseite der mindestens einen leitfähigen Struktur wird eine Folienlage angeordnet. Mindestens eine zweite Schnittlinie wird in einen Bereich der Folienlage derart eingebracht, dass die Folienlage durch die mindestens eine zweite Schnittlinie an dem Bereich der Folienlage durchtrennt wird und ein zweiter unter dem Bereich der Folienlage angeordneter Bereich der Trägerfolie unversehrt bleibt.

Gemäß einer möglichen Ausführungsform des Verfahrens kann
mindestens eine dritte Schnittlinie in die Trägerfolie eingebracht werden, die die Trägerfolie vor dem Aufbringen der elektrisch leitfähigen Folie durchschneidet. Gleichzeitig mit dem Einbringen der mindestens einen zweiten Schnittlinie kann mindestens eine vierte Schnittlinie in die Folienlage und in die darunter angeordnete Trägerfolie eingebracht werden, die sowohl die Folienlage als auch die Trägerfolie durchtrennt. Bei einer derartigen Ausführungsform haftet der ausgestanzte Teil der Trägerfolie nach dem Abziehen der Folienlage von der Trägerfolie weiterhin unter einem Teil der mindestens einen leitfähigen Struktur.

Zur Kontaktierung der mindestens einen leitfähigen Struktur kann in die Folienlage eine Aussparung eingebracht werden, so dass beim Anordnen der mindestens einen leitfähigen Struktur auf der Folienlage ein Bereich der mindestens einen leitfähigen Struktur zur Kontaktierung freiliegt.

Mit dem Folienverbund wird eine hoch funktionelle, einfach zu handhabende und leicht zu kontaktierende elektrisch leitfähige Struktur zur Verfügung gestellt, welche diverse Verwendungsmöglichkeiten eröffnet. Der Folienverbund kann zum Beispiel zur Verbindung von Komponenten elektrischer beziehungsweise elektronischer Schaltungen, zur Herstellung von Steckerverbindungen, zur Herstellung insbesondere einer kapazitiven oder resistiven Sensorik, für eine Heizung oder für Antennenaufbauten verwendet werden.

Die Erfindung wird im Folgenden anhand von Figuren, die Ausführungsbeispiele der vorliegenden Erfindung zeigen, näher erläutert.

Es zeigen:
- Figur 1: eine Ausführungsform eines Folienverbundes mit einer elektrisch leitfähigen Struktur,
- Figur 2A: eine Ausführungsform eines Folienverbundes mit einer elektrisch leitfähigen Struktur, vorbereitet zur Kontaktierung in einem Stecker,
- Figur 2B: eine Ausführungsform eines Folienverbundes mit einer elektrisch leitfähigen Struktur appliziert auf ein Substrat,
- Figur 3: eine Draufsicht auf eine Ausführungsform eines Folienverbundes mit einer elektrisch leitfähigen Struktur,
- Figur 4: eine Ausführungsform eines Verfahrens zum Herstellen eines Folienverbundes mit einer elektrisch leitfähigen Struktur,
- Figur 5: eine Ausführungsform eines Folienverbundes mit einer elektrisch leitfähigen Struktur,
- Figur 6A: eine Ausführungsform eines Folienverbundes mit einer elektrisch leitfähigen Struktur, vorbereitet zur Kontaktierung in einem Stecker,
- Figur 6B: eine Ausführungsform eines Folienverbundes mit einer elektrisch leitfähigen Struktur appliziert auf ein Substrat,
- Figur 7: eine Draufsicht auf eine Ausführungsform eines Folienverbundes mit einer elektrisch leitfähigen Struktur,
- Figur 8: eine Ausführungsform eines Verfahrens zum Herstellen eines Folienverbundes mit einer elektrisch leitfähigen Struktur.

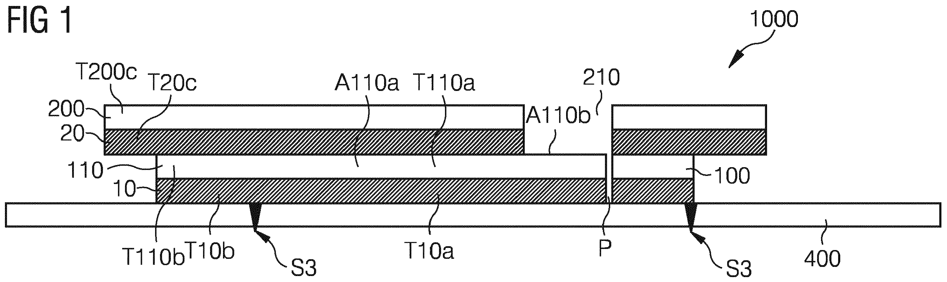

Figur 1 zeigt eine Schnittansicht einer Ausführungsform 1000 eines Folienverbundes mit elektrischer Funktionalität. Der Folienverbund umfasst mindestens eine leitfähige Struktur 110 und eine an einer Unterseite der mindestens einen leitfähigen Struktur angeordnete Verbindungsschicht 10. Die Verbindungsschicht 10 weist eine Haftwirkung zum Aufbringen der mindestens einen leitfähigen Struktur auf ein Substrat auf. Des Weiteren weist der Folienaufbau eine Folienlage 200 und eine Verbindungsschicht 20 auf. Die Verbindungsschicht 20 ist zwischen einer Oberseite der mindestens einen leitfähigen Struktur 110 und der Folienlage 200 angeordnet. Die Verbindungsschicht 20 weist eine Haftwirkung, durch die die Folienlage 200 an der mindestens einen leitfähigen Struktur haftet, auf. Die Verbindungsschicht 10 und die Verbindungsschicht 20 können beispielsweise als eine Klebstoffbeschichtung oder als ein Haftvermittler, insbesondere als eine Lackschicht, ausgebildet sein.

Der Folienverbund 1000 umfasst des Weiteren eine Trägerfolie 400, auf der die mindestens eine leitfähige Struktur 110 und die Folienlage 200 angeordnet sind. Die unter der mindestens einen leitfähigen Struktur 110 angeordnete Verbindungsschicht 10 haftet an der Trägerfolie 400. Insbesondere haften Bereiche T10a und T10b der Verbindungsschicht 10 an der Trägerfolie. Ein Bereich T110a der mindestens einen leitfähigen Struktur 110 haftet an dem Bereich T10a der Verbindungsschicht 10. Ebenso haftet ein sich an den Bereich T110a anschließender Bereich T110b der mindestens einen leitfähigen Struktur 110 an dem Bereich T10b der Verbindungsschicht 10. Die Verbindungsschicht 10 weist eine derartige Haftwirkung auf, dass die mindestens eine leitfähige Struktur einerseits an der Trägerfolie sicher haftet und dass andererseits die mindestens eine leitfähige Struktur 110 zusammen mit der Verbindungsschicht 10 von der Trägerfolie 400 abgezogen werden kann.

Über dem Bereich T110a der mindestens einen leitfähigen Struktur 110 ist ein Bereich T20a der Verbindungsschicht 20 angeordnet. Über dem Bereich T110b der mindestens einen leitfähigen Struktur 110 ist ein Bereich T20b der Verbindungsschicht 20 angeordnet. Über den Bereichen T20a und T20b der Verbindungsschicht 20 haften Bereiche T200a und T200b der Folienlage 200 an der Verbindungsschicht 20. Durch die Verbindungsschicht 20 wird die mindestens eine leitfähige Struktur 110 zuverlässig an der Folienlage 200 gehalten, um die mindestens eine leitfähige Struktur 110 zu schützen. Die Haftkraft der Verbindungsschicht 20 auf der mindestens einen leitfähigen Struktur ist größer als die Haftkraft der Verbindungsschicht 10 auf der Trägerfolie 400, so dass der Folienaufbau aus der Verbindungsschicht 10, der mindestens einen leitfähigen Struktur 110, der Verbindungsschicht 20 und der Folienlage 200 als Ganzes von der Trägerfolie abgelöst werden kann.

Die Folienlage 200 weist einen Bereich T200c und die an der Folienlage 200 unterseitig angeordnete Verbindungsschicht 20 weist einen Bereich T20c auf, wobei sich der Bereiche T200c der Folienlage 200 und der Bereich T20c der Verbindungsschicht 20 über die mindestens eine leitfähige Struktur 110 hinaus erstrecken. Der Bereich T20c der Verbindungsschicht 20 haftet ebenfalls an der Trägerfolie 400, so dass die mindestens eine leitfähige Struktur 110 von der Folienlage 200 abgedeckt wird. In Figur 1 ist der Bereich T200c der Folienlage 200 und der Bereich T20c der Verbindungsschicht 20 der besseren Darstellung wegen frei über die leitfähige Struktur 110 hinausragend dargestellt. Die mindestens eine leitfähige Struktur 110 ist somit zwischen der Folienlage 200 und der Trägerfolie 400 eingebettet.

Zur Kontaktierung der mindestens einen leitfähigen Struktur 110 kann in einem Bereich der Folienlage 200 eine Aussparung 210 vorgesehen sein. Somit ist ein Abschnitt A110a der mindestens einen leitfähigen Struktur von der Folienlage 200 bedeckt, während im Bereich der Aussparung 210 ein Abschnitt A110b der mindestens einen leitfähigen Struktur 110 freiliegend angeordnet, das heißt von der Folienlage 200 unbedeckt ist, und von außen kontaktiert werden kann.

In die Trägerfolie 400 kann mindestens eine Schnittlinie S3 eingebracht sein, die senkrecht zur Blattebene in Figur 1 verläuft und die Trägerfolie komplett durchtrennt. Bei der in Figur 1 gezeigten Ausführungsform sind zwei Schnittlinien S3 in die Trägerfolie eingebracht. Es können noch weitere Schnittlinien in die Trägerfolie eingebracht werden, die die Trägerfolie komplett durchtrennen. Dadurch kann ein Abschnitt der Trägerfolie, der zumindest einen Teil der leitfähigen Struktur unterseitig abdeckt, aus der übrigen Trägerfolie ausgeschnitten werden. Beim Abziehen des Folienaufbaus aus der Verbindungsschicht 10, der mindestens einen leitfähigen Struktur 110, der Verbindungsschicht 20 und der Folienlage 200 von der Trägerfolie 400 bleibt der mindestens eine ausgestanzte Bereich der Trägerfolie 400 unter dem Teil T110a der mindestens einen leitfähigen Struktur 110 haften. Die weiteren Schnittlinien können beispielsweise parallel zu der mindestens einen leitfähigen Struktur beziehungsweise senkrecht zu den Schnittlinien S3 verlaufen.

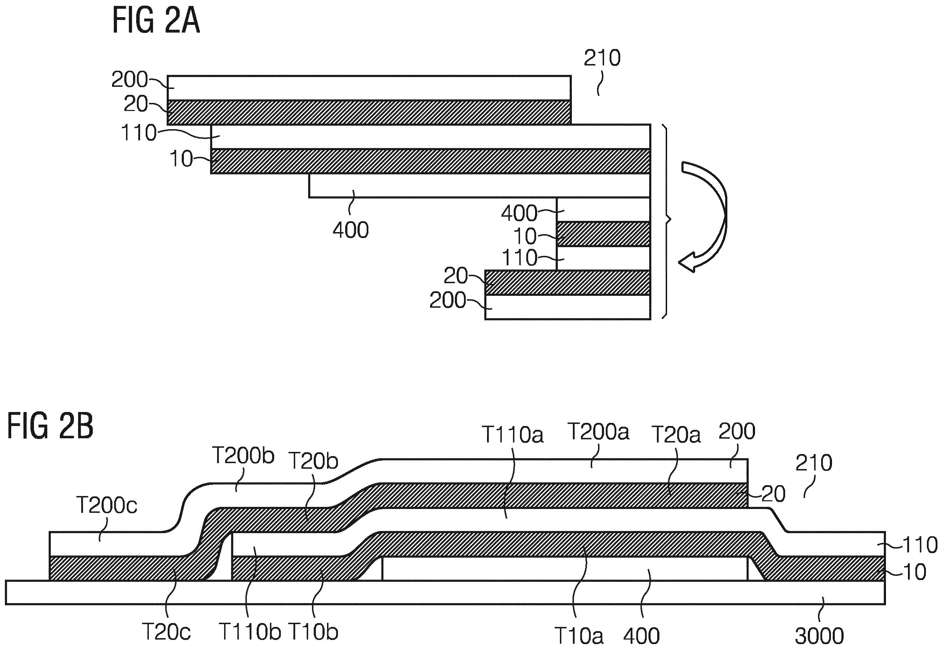

Der Folienverbund weist mit der elektrisch leitfähigen Struktur eine elektrische Funktionalität auf und ist flexibel einsetzbar ist. Der Folienaufbau aus der Verbindungsschicht 10, der mindestens einen leitfähigen Struktur 110, der Verbindungsschicht 20 und der Folienlage 200 kann auf einfache Weise von der Trägerfolie abgezogen werden und mittels der Verbindungsschicht 10 auf ein Substrat aufgebracht werden. Des Weiteren kann die elektrisch leitfähige Struktur an einen Stecker angebunden werden. Entsprechende Ausführungsformen des Folienverbundes, vorbereitet zur Anbindung an einen Stecker beziehungsweise appliziert auf einem Substrat sind in den Figuren 2A und 2B dargestellt. Gleiche Folienbestandteile sind mit denselben Bezugszeichen wie in Figur 1 bezeichnet.

Figur 2A zeigt beispielhaft eine Ausführungsform des Folienverbundes 1000 zur Kontaktierung mit einem Stecker. Wenn die Nenndicke im Steckerbereich zur Kontaktierung größer als die Dicke des Folienverbundes ist, kann ein Teil des Folienverbundes, der auf einer Seite der Aussparung 210 angeordnet ist, umgefaltet werden, um somit die Dicke des Folienverbundes im Kontaktierungsbereich der Aussparung 210 zu erhöhen. Zum Falten beziehungsweise Knicken des neben der Aussparung 210 liegenden Bereichs des Folienverbundes kann in dem Folienverbund eine Perforation P oder eine sonstige Trenn- oder Schwächungslinie, zum Beispiel eine Rillung, vorgesehen sein. Nach dem Umfalten bildet der freiliegende Abschnitt der mindestens einen leitfähigen Struktur 110 eine sogenannte Anschlussfahne zur Kontaktierung der mindestens einen leitfähigen Struktur. Durch das Umfalten kann die Dicke der Anschlussfahne entsprechend der Nenndicke des Steckers vergrößert und die Stabilität im Bereich der Anschlussfahne erhöht werden. Darüber hinaus ist eine beidseitige Kontaktierung der Anschlussfahne möglich.

Figur 2B zeigt den nach dem Abziehen der Trägerfolie 400 von dem Folienverbund 1000 verbleibenden Folienaufbau aus der Folienlage 200, der Verbindungsschicht 20, der mindestens einen leitfähigen Struktur 110 und der Verbindungsschicht 10 mit dem an ihrer Unterseite haftenden mindestens einen Teil der ausgestanzten Trägerfolie 400 nach dem Aufkleben auf ein Substrat 3000, zum Beispiel einer Bedienblende. Der Folienaufbau ist derart ausgebildet, dass im Zustand des Aufklebens auf dem Substrat 3000 der Teil T110a der mindestens einen leitfähigen Struktur 110, der Teil T10a der Verbindungsschicht 10, der Teil T20a der Verbindungsschicht 20 und der Teil T200a der Folienlage 200 auf der Trägerfolie 400 verbleiben. Der Teil T110b der mindestens einen leitfähigen Struktur haftet mittels des Teils T10b der Verbindungsschicht 10 unmittelbar auf dem Substrat 3000. Der über dem Teil T110b der mindestens eine leitfähigen Struktur 110 angeordnete Teil T200b der Folienlage 200 haftet mittels des Teils T20b der Verbindungsschicht 20 an dem Teil T110b der mindestens einen leitfähigen Struktur. Der sich an den Abschnitt T200b der Folienlage 200 anschließende Bereich T200c der Folienlage 200 haftete mittels dem Abschnitt T20c der Verbindungsschicht 20 unmittelbar auf dem Substrat 3000.

Der freiliegende, nicht abgedeckte Bereich der mindestens einen leitfähigen Struktur 110 bildet eine sogenannte Anschlussfahne zur Kontaktierung der mindestens einen leitfähigen Struktur. Der freiliegende Abschnitt der mindestens einen leitfähigen Struktur haftet unmittelbar auf dem Substrat 3000. Gemäß einer weiteren möglichen Ausführungsform kann die leitfähige Struktur 110 mit der an ihr unterseitig angeordneten Verbindungsschicht 10 im Bereich der Anschlussfahne mit der Trägerfolie 400 unterlegt sein und haftet daher nicht auf dem Substrat.

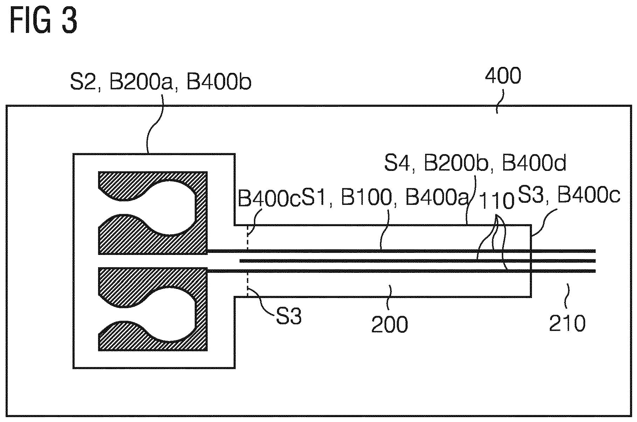

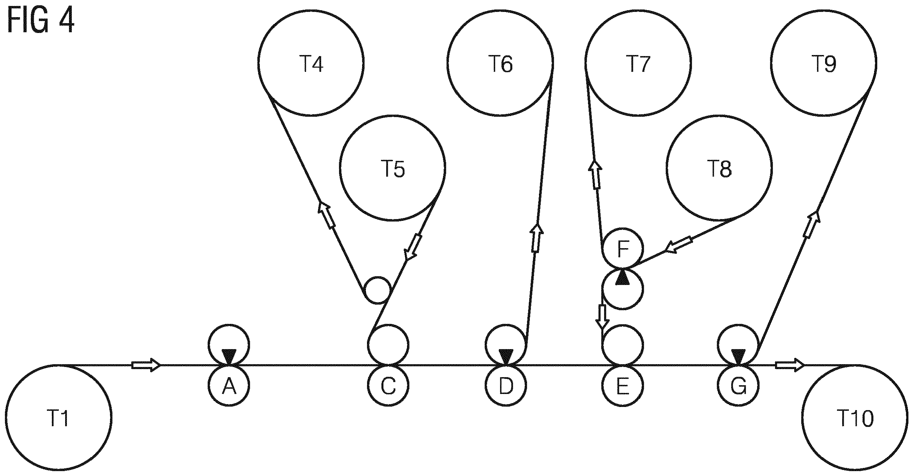

Figur 3 zeigt eine Draufsicht auf eine mögliche Ausgestaltung des Folienverbundes 1000 aus der Trägerschicht 400, der mindestens einen leitfähigen Struktur 110 mit der Verbindungsschicht 10 und der Folienlage 200 mit der Verbindungsschicht 20. Die Herstellung eines solchen Folienverbundes mit einer elektrisch leitfähigen Struktur 110 in Form von 2 Touch-Sensoren mit Zuleitungen und Schirmung wird anhand von Figur 4 in Verbindung mit Figur 3 im Folgenden näher erläutert.

Figur 4 zeigt eine Ausführungsform eines Verfahrens zum Herstellen des Folienverbundes 1000 mit einer elektrisch leitfähigen Struktur. Auf einer Trommel T1 befindet sich eine Bahn der Trägerfolie 400, die in Richtung einer Kaschiereinrichtung C abgewickelt werden kann. Auf einer Trommel T5 ist eine Bahn einer elektrisch leitfähigen Folie 100 mit der an ihr unterseitig angeordneten Verbindungsschicht 10 aufgewickelt. Bei dem in Figur 4 skizzierten Verfahren ist die Verbindungsschicht 10 beispielsweise als Klebstoffbeschichtung, die von einer Schutzschicht abgedeckt ist, ausgebildet. Die elektrisch leitfähige Folie 100 wird als Folienbahn von der Trommel T5 abgewickelt. Die Schutzschicht wird an einer Abzieheinheit, beispielsweise einer Umlenkrolle, von der Verbindungsschicht 10 abgelöst und auf einer Trommel T4 aufgewickelt. Die Folie 100 mit der darunter angeordneten Verbindungsschicht 10 wird der Kaschiereinrichtung C zugeführt. An der Kaschiereinrichtung C wird die Folie 100 auf der Trägerfolie 400 angeordnet. Dazu kann die Bahn der Folie 100 mittels der Verbindungsschicht 10 auf die Bahn der Trägerfolie 400 aufkaschiert werden.

Der Folienaufbau aus der Trägerfolie 400 und der aufkaschierten elektrisch leitfähigen Folie 100 wird nachfolgend einer Stanzeinrichtung D zum Stanzen von Konturen in die Folie 100 zugeführt. Mittels der Stanzeinrichtung D wird mindestens eine Schnittlinie S1 in einen Bereich B100 der Folie 100 und die unter diesen Bereich liegende Verbindungsschicht 10 derart eingebracht, dass die Folie 100 und die darunter liegende Verbindungsschicht 10 durch die mindestens eine Schnittlinie S1 an dem Bereich B100 der Folie 100 durchtrennt werden und ein unter dem Bereich B100 der Folie 100 angeordneter Bereich B400a der Trägerfolie 400 unversehrt bleibt. Die Bereiche B100 und B400a sind in Figur 3 gezeigt. Durch das Einbringen der Schnittlinie S1 wird die Struktur der mindestens einen leitfähigen Struktur 110 in der Folie 100 gebildet. Die mindestens eine leitfähige Struktur 110 ist durch die mindestens eine Schnittlinie S1 von einem restlichen Teil der Folie 100 getrennt. Am Ausgang der Stanzeinrichtung D wird dieser restliche auch als Gitter bezeichnete Teil der Folie 100 von der Trägerfolie 400 abgezogen und auf einer Trommel T6 aufgewickelt. Hinter der Stanzeinrichtung D ist auf der Trägerfolie 400 mindestens eine leitfähige Struktur 110 angeordnet.

Eine Trommel T8 enthält eine Bahn der Folienlage 200 mit der unterseitig angebrachten Verbindungsschicht 20. Die Verbindungsschicht 20 kann wie die Verbindungsschicht 10 als Klebstoffbeschichtung ausgeführt sein. Die Folienlage 200 wird mit der Verbindungsschicht 20 von der Trommel T8 abgerollt und kann einer Stanzeinrichtung F zugeführt werden. In der Stanzeinrichtung F kann die in Figur 1 gezeigte Aussparung 210 in die Folienlage 200 und die Verbindungsschicht 20 eingebracht werden, bevor die Bahn der Folienlage 200 auf die mindestens eine leitfähige Struktur 110 aufkaschiert wird. Die Verbindungsschicht 20 kann von einer Schutzfolie bedeckt sein. Am Ausgang der Stanzeinrichtung F wird die Schutzfolie abgezogen und auf einer Trommel T7 aufgewickelt.

Die mit der Verbindungsschicht 20 beschichtete Folienbahn 200 wird anschließend einer Kaschiereinrichtung E zugeführt. In der Kaschiereinrichtung E wird die Folienlage 200 auf einer Oberseite der mindestens einen leitfähigen Struktur 110 und der Trägerfolienbahn 400 angeordnet. Dazu wird in der Kaschiereinrichtung E die Folienlage 200 mittels der Verbindungsschicht 20 auf die mindestens eine leitfähige Struktur 110 und die Trägerfolie 400 aufkaschiert.

Der Folienaufbau aus der Trägerfolie 400, der mindestens einen leitfähigen Struktur 110, die mittels der unterseitig angeordneten Verbindungsschicht 10 auf der Trägerfolie 400 haftet, und der Folienlage 200, die mittels der unterseitig angeordneten Verbindungsschicht 20 auf der Oberseite der mindestens einen leitfähigen Struktur 110 aufgeklebt ist, wird anschließend einer Stanzeinrichtung G zugeführt.

In der Stanzeinrichtung G wird mindestens eine Schnittlinie S2 in einen Bereich B200a der Folienlage 200 und der darunter liegende Verbindungsschicht 20 derart eingebracht, dass die Folienlage 200 und die darunter liegende Verbindungsschicht 20 durch die mindestens eine Schnittlinie S2 an dem Bereich B200a der Folienlage 200 durchtrennt werden und ein unter dem Bereich der Folienlage 200 angeordneter Bereich B400b der Trägerfolie 400 unversehrt bleibt. Somit wird in der Stanzeinrichtung G die Kontur des Folienaufbaus aus der Verbindungsschicht 10, der mindestens einen leitfähigen Struktur 110, der Verbindungsschicht 20 und der Folienlage 200 auf der Trägerfolie 400 gestanzt. Das abgetrennte Restgitter der Folienlage 200 wird auf einer Trommel T9 aufgewickelt. Der verbleibende Folienverbund 1000 wird auf einer Trommel T10 aufgewickelt.

Zum Ausstanzen eines Abschnitts der Trägerfolie 400, der bei einem Abziehen des Folienaufbaus aus der Verbindungsschicht 10, der mindestens einen leitfähigen Struktur 110, der Verbindungsschicht 20 und der Folienlage 200 unter einem Teil T110a der mindestens einen leitfähigen Struktur haftet, kann gemäß einer möglichen Ausführungsform zwischen der Trommel T1 und der Kaschiereinrichtung C eine Stanzeinrichtung A angeordnet sein. Mittels der Stanzeinrichtung A kann mindestens eine Schnittlinie S3 in einen Bereich B400c der Trägerfolie 400 derart eingebracht werden, dass die Trägerfolie 400 an dem Bereich B400c der Trägerfolie durchschnitten wird. Die mindestens eine Schnittlinie S3 kann beispielsweise senkrecht zu der mindestens einen leitfähigen Struktur 110 in der Trägerfolie 400 verlaufen.

Zum Ausstanzen des Abschnitts der Trägerfolie kann in der Stanzeinrichtung G mindestens eine Schnittlinie S4 in einen Bereich B200b der Folienlage 200 und der darunter liegenden Verbindungsschicht 20 und in einen unter dem Bereich B200b der Folienlage 200 angeordneten Bereich B400d der Trägerfolie 400 derart eingebracht werden, dass die Folienlage 200 und die Verbindungsschicht 20 an dem Bereich B200b und die Trägerfolie 400 an dem Bereich B400d komplett durchtrennt werden. Die Schnittlinie S4 kann beispielsweise parallel zum Verlauf der mindestens einen leitfähigen Struktur 110 und beispielsweise senkrecht zu der mindestens einen Schnittlinie S3 verlaufen. Durch das Einbringen der Schnittlinien S3 und S4 bleibt nach dem Abziehen des Folienaufbaus aus der Verbindungsschicht 10, der mindestens einen leitfähigen Struktur 110, der Verbindungsschicht 20 und der Folienlage 200 von der Trägerfolie 400 ein Teil der Trägerfolie unter dem Teil T110a der mindestens einen leitfähigen Struktur 110 haften.

Bei der anhand von Figur 4 skizzierten Ausführungsform eines Herstellungsverfahrens zur Herstellung des in Figur 1 gezeigten Folienverbundes sind die Verbindungsschichten 10 und 20 beispielhaft als Klebstoffbeschichtungen ausgeführt, die an der elektrisch leitfähigen Folie 100 beziehungsweise der Folienlage 200 unterseitig angeordnet sind. Die Verbindungsschichten 10 und 20 können auch als separate Schichten bereitgestellt werden, die im Laufe des Herstellungsverfahrens auf die elektrisch leitfähige Folie 100 beziehungsweise die Folienlage 200 aufgebracht werden.

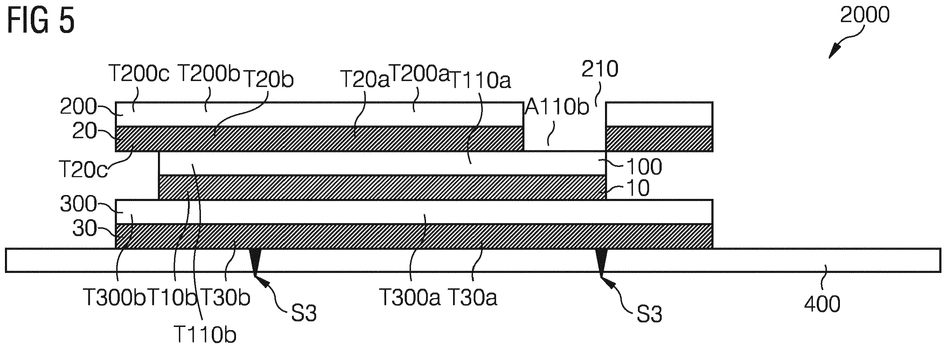

Figur 5 zeigt eine weitere Ausführungsform eines Folienverbundes 2000 mit elektrischer Funktionalität. Im Unterschied zu der in Figur 1 gezeigten Ausführungsform weist der Folienverbund zusätzlich eine Folienlage 300 und eine Verbindungsschicht 30, die an der Unterseite der Folienlage 300 angeordnet ist, auf. Ein Bereich T300a der Folienlage 300 haftet mit seiner Oberseite an dem Bereich T10a der Verbindungsschicht 10. Ein sich an den Bereich T300a anschließender Bereich T300b der Folienlage 300 haftet mit seiner Oberseite an dem Bereich T10b der Verbindungsschicht 10. Ein sich an den Bereich T300b der Folienlage 300 anschließender Bereich T300c der Folienlage 300 haftete mit seiner Oberseite an dem Bereich T20c der Verbindungsschicht 20, der sich zusammen mit dem über ihm angeordneten Bereich T200c der Folienlage 200 über die mindestens eine leitfähige Struktur 110 hinaus erstreckt. Somit ist die mindestens eine leitfähige Struktur 110 mit ihren Bereichen T110a und T110b zwischen den Folienlagen 200 und 300 eingebettet.

Sämtliche Bereiche T30a, T30b und T30c der Verbindungsschicht 30 haften auf der Trägerfolie 400. Die Verbindungsschicht 30 kann beispielsweise als eine Klebstoffbeschichtung oder als ein Haftvermittler, insbesondere als eine Lackschicht, ausgebildet sein. Die Verbindungsschicht 30 ist somit zwischen der Trägerfolie 400 und der Folienlage 300 angeordnet. Die Haftwirkung der Verbindungsschicht 30 ist derart ausgebildet, dass der Folienaufbau aus der Verbindungsschicht 30, der Folienlage 300, der Verbindungsschicht 10, der mindestens eine leitfähigen Struktur 110, der Verbindungsschicht 20 und der Folienlage 200 sicher an der Trägerfolie haftet und andererseits, insbesondere manuell als Ganzes von der Trägerfolie 400 abgezogen werden kann. Die Haftkraft der Verbindungsschicht 20 auf der mindestens einen leitfähigen Struktur ist höher als die Haftkraft der Verbindungsschicht 30 auf der Trägerfolie 400.

Ansonsten haften die Bereiche T10a, T10b der Verbindungsschicht 10, die Bereiche T110a, T110b der mindestens einen leitfähigen Struktur 110, die Bereiche T20a, T20b der Verbindungsschicht 20 und die Bereiche T200a, T200b der Folienlage 200 wie anhand von Figur 1 beschrieben zueinander.

In der Trägerfolie 400 können Schnittlinien S3 vorgesehen sein, durch die ein Teil der Trägerfolie 400 in einer Richtung aus der Trägerfolie 400 ausgestanzt werden kann. Zum vollständigen Ausstanzen des Abschnitts der Trägerfolie wird eine weitere Schnittlinie S4 in die Trägerfolie eingebracht, die die Trägerfolie beispielsweise parallel zu der mindestens einen leitfähigen Struktur 110 und somit beispielsweise senkrecht zu der Schnittlinie S3 durchtrennt. Wenn der Folienaufbau aus der Verbindungsschicht 30, der Folienlage 300, der Verbindungsschicht 10, der mindestens einen leitfähigen Struktur 110, der Verbindungsschicht 20 und der Folienlage 200 von der Trägerfolie 400 abgehoben wird, haftet der ausgestanzte Teil der Trägerfolie 400 an dem Teil T30a der Verbindungsschicht 30.

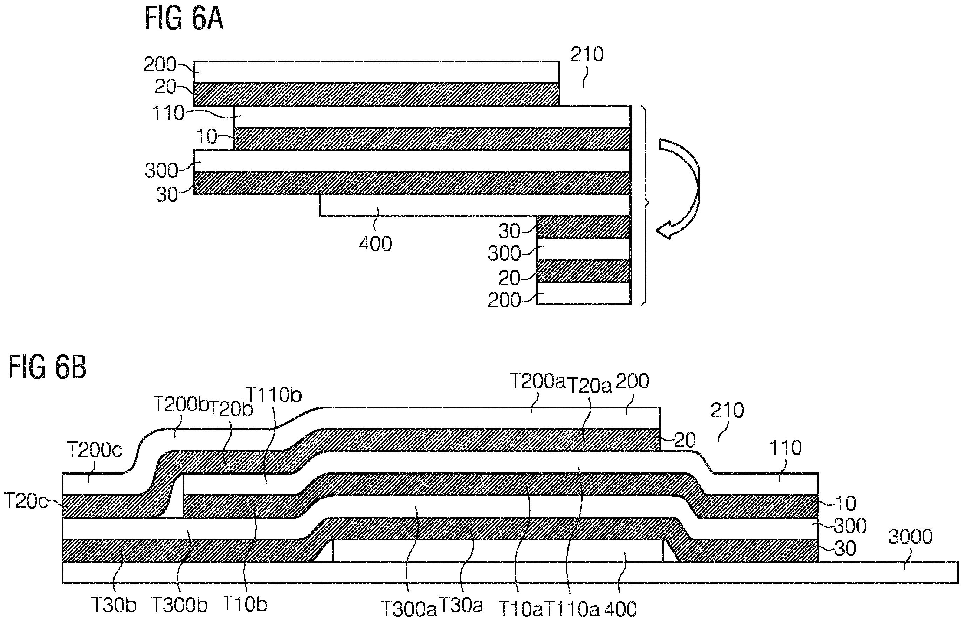

Figur 6A zeigt eine Ausführungsform des nach dem Abziehen der Trägerfolie 400 von dem Folienverbund 2000 verbleibenden Folienaufbaus aus der Verbindungsschicht 30, des an ihr unterseitig haftenden Abschnitts der Trägerfolie 400, der Folienlage 300, der Verbindungsschicht 10, der mindestens einen leitfähigen Struktur 110, der Verbindungsschicht 20 und der Folienlage 200 zum Fixieren in einem Stecker. Wenn der Folienaufbau eine Höhe aufweist, die unter der Nenndicke einer leitfähigen Struktur im Kontaktierungsbereich des Steckers liegt, kann ähnlich wie bei der Ausführungsform des Folienverbunds 1000 der Figur 2A ein Teil des Folienaufbaus, der neben der Aussparung 210 liegt, zur Erhöhung der Dicke im Kontaktierungsbereich des Steckers umgefaltet werden.

Figur 6B zeigt die Ausführungsform des Folienverbundes 2000 nach dem Abziehen der Trägerfolie und einem nachfolgenden Applizieren auf ein Substrat, beispielsweise auf eine Bedienblende 3000. Der Folienverbund 2000 ist derart ausgebildet, dass im auf dem Substrat 3000 aufgeklebten Zustand der Teil T110a der leitfähigen Struktur 110, der Teil T200a der Folienlage 200 und der Teil T300a der Folienlage 300 auf der Trägerfolie 400 angeordnet ist. Die Trägerfolie 400 ist unmittelbar auf dem Substrat 3000 angeordnet. Die Teile T300b und T300c der Folienlage 300 haften mittels der unmittelbar auf dem Substrat haftenden Verbindungsschicht 30 auf dem Substrat 3000.

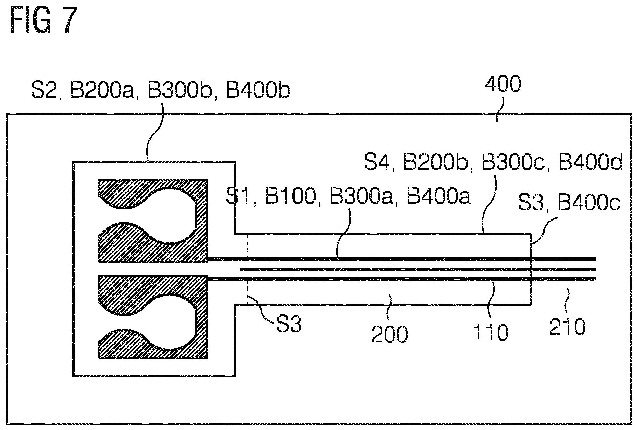

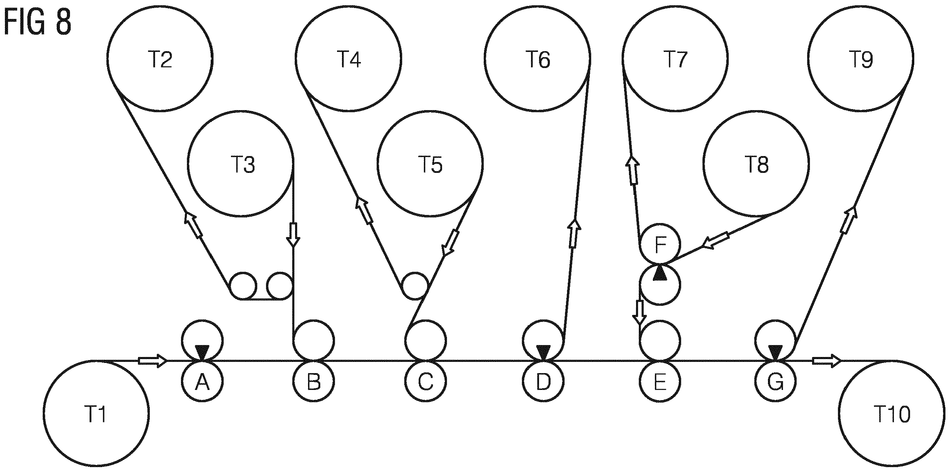

Figur 7 zeigt eine Draufsicht auf eine mögliche Ausgestaltung des Folienverbundes 2000 aus der Trägerfolie 400, der Verbindungsschicht 30, der Folienlage 300, der Verbindungsschicht 10, der mindestens einen leitfähigen Struktur 110, der Verbindungsschicht 20 und der Folienlage 200. Die Herstellung eines solchen Folienverbundes mit einer elektrisch leitfähigen Struktur 110, beispielsweise in Form von 2 Touch-Sensoren mit Zuleitung und Schirmung, wird anhand von Figur 8 in Verbindung mit Figur 7 im Folgenden näher erläutert, wobei im Wesentlichen auf die Unterschiede zu dem in Figur 4 dargestellten Verfahren eingegangen wird.

Figur 8 zeigt eine Ausführungsform eines Verfahrens zum Herstellen des Folienverbundes 2000 mit der elektrisch leitfähigen Struktur 110. Im Unterschied zu der in Figur 3 dargestellten Ausführungsform des Herstellungsverfahrens ist zwischen der Trommel T1 zum Abwickeln der Bahn der Trägerfolie 400 beziehungsweise der optional vorhandenen Stanzeinrichtung A und der Kaschiereinrichtung C eine Kaschiereinrichtung B vorgesehen. Die Kaschiereinrichtung B ist mit einer Trommel T3 gekoppelt, auf der eine Bahn der Folienlage 300 mit der Verbindungsschicht 30, die beispielsweise in Form einer Klebstoffbeschichtung ausgebildet und an der Folienlage 300 unterseitig angeordnet sein kann, und einer auf der Verbindungsschicht 30 angebrachten Schutzschicht aufgewickelt ist. Die Folienlage 300 mit der Verbindungsschicht 30 und der Schutzschicht wird von der Trommel T3 abgewickelt. Eine Folienbahn der Schutzschicht wird anschließend an einer Abzieheinheit, beispielsweise einer Umlenkrolle, von der Verbindungsschicht 30 abgezogen und auf eine Trommel T2 aufgewickelt.

Die verbleibende Bahn aus der Folienlage 300 und der Verbindungsschicht 30 wird der Kaschiereinrichtung B zugeführt. In der Kaschiereinrichtung B wird die Folienlage 300 mit der Verbindungsschicht 30 auf die Trägerfolie 400 aufkaschiert.

In der Kaschiereinrichtung C wird nachfolgend die Folienlage 100 mittels der Verbindungsschicht 10 auf die Folienlage 300 aufkaschiert. Des Weiteren wird mittels der Stanzeinrichtung D die Kontur der mindestens einen leitfähigen Struktur 110 aus der Folienlage 100 ausgestanzt, indem eine Schnittlinie S1 in einen Bereich B100 der elektrisch leitfähigen Folie 100 und der darunter angeordneten Verbindungsschicht 10 eingebracht wird, die die Folienlage 100 und die Verbindungsschicht 10 durchtrennt, wohingegen ein darunter angeordneter Bereich B300a der Folienlage 300 und der Verbindungsschicht 30 sowie ein unter dem Bereich B300a angeordneter Bereich B400a der Trägerfolie nicht durchtrennt wird.

Nach dem Abziehen des ausgestanzten Gitters der elektrisch leitfähigen Folie 100 wird in der Kaschiereinrichtung E die Folienlage 200 auf die mindestens eine leitfähige Struktur 110 und die Folienlage 300 aufkaschiert. In der Stanzeinrichtung G wird die mindestens eine Schnittlinie S2 in den Folienverbund derart eingebracht, dass ein Bereich B200a der Folienlage 200 und der darunter angeordneten Verbindungsschicht 20 sowie ein unter dem Bereich B200a der Folienlage 200 angeordneter Bereich B300b der Folienlage 300 und der darunter liegenden Verbindungsschicht 30 komplett durchtrennt werden. Ein unter dem Bereich B300b angeordneter Bereich B400b der Trägerfolie 400 bleibt unversehrt.

Gemäß einer möglichen Ausführungsform kann in der Stanzeinrichtung G mindestens eine Schnittlinie S4 in einen Bereich B200b der Folienlage 200 und der Verbindungsschicht 20 sowie in einen unter dem Bereich B200b der Folienlage 200 angeordneten Bereich B300c der Folienlage 300 und der Verbindungsschicht 30 sowie einen unter dem Bereich B300c der Folienlage 300 angeordneten Bereich B400d der Trägerfolie 400 derart eingebracht werden, dass die Folienlage 200 mit der Verbindungsschicht 20 an dem Bereich B200b und die Folienlage 300 mit der Verbindungsschicht 30 an dem Bereich B300c und die Trägerfolie 400 an dem Bereich B400d komplett durchtrennt werden. Die Schnittlinie S4 kann beispielsweise parallel zu der mindestens einen leitfähigen Struktur 110 und beispielsweise senkrecht zu der mindestens einen Schnittlinie S3, die in der Stanzeinrichtung A in die Trägerfolie 400 eingebracht wird, verlaufen.

Bei der anhand von Figur 8 skizzierten Ausführungsform des Herstellungsverfahrens zur Herstellung des in Figur 5 gezeigten Folienverbundes sind die Verbindungsschichten 10, 20 und 30 beispielhaft als Klebstoffbeschichtungen ausgeführt, die an einer elektrisch leitfähigen Folie 100, der Folienlage 200 und der Folienlage 300 unterseitig angeordnet sind. Die Verbindungsschichten 10, 20 und 30 können auch als separate Schichten bereitgestellt werden, die im Laufe des Herstellungsverfahrens auf die elektrisch leitfähige Folie 100 beziehungsweise die Folienlagen 200 und 300 aufgebracht werden.

Bei dem Folienverbund 1000 und 2000 können die durch die Aussparung 210 freigelegten Abschnitte A110b der mindestens einen leitfähigen Struktur 110 vor Korrosion geschützt werden, indem beispielsweise als Folie 100 eine verzinnte Leiterfolie verwendet wird.

Wenn die leitende Schicht Korrosionsneigung besitzt, besteht die weitere Möglichkeit, die freigelegten Anschlussfahnen A110b oder andere freiliegende Bereiche nachträglich zu verzinnen. Gemäß einer weiteren Ausführungsform kann im relevanten Bereich der Anschlussfahnen verdruckbare Leitpaste, beispielsweise Carbonpaste oder Silberleitpaste, aufgedruckt werden. Dies kann wahlweise bereits vor dem Herstellungsprozess, im Herstellungsprozess oder auch nachher erfolgen. Eine weitere Möglichkeit des Korrosionsschutzes besteht darin, die Anschlussfahnen mindestens im Kontaktierungsbereich nach erfolgter Kontaktierung des Folienverbundes in einer Baugruppe zu vergießen. Ein Stecker kann dazu beispielsweise innen mit Vergussmasse ausgegossen werden.

Wenn die Verbindungsschichten 10, 20 und 30 als Klebstoffbeschichtungen auf der elektrisch leitfähigen Folie 100 und den Folienlagen 200 und 300 ausgebildet sind, können verschiedene Arten von Klebstoffen, beispielsweise hitzereaktive Klebstoffe oder verdruckbare Klebstoffe, verwendet werden, um die einzelnen Lagen des Folienverbundes fest zu verbinden und so mechanisch zu stabilisieren. Ebenso ist die Verwendung von Transferklebstoffen, die als reine Klebstoffbeschichtung ausgebildet sind, oder alternativ die Verwendung von Doppelklebebändern, das heißt einer Klebstoffbeschichtung mit Verstärkung durch beispielsweise eine Folien- oder Papierzwischenlage, möglich. Die Klebstoffbeschichtungen können als ablösbar haftende oder als permanent haftende Klebstoffe ausgeführt sein. Die Klebekräfte des jeweiligen Klebstoffes sind auf das Ablöseverhalten der aufzubringenden Oberfläche abzustimmen. Die Klebekräfte sollten dabei vorzugsweise im Bereich von 0,01 N/25 mm bis 50 N/25 mm liegen.

Im Bereich der Anschlussfahne kann die Trägerfolie ohne Stanzung beziehungsweise Schlitzung ausgeführt sein. In diesem Fall ist die Klebstoffbeschichtung der Anschlussfahne nach dem Abziehen der Trägerfolie unten offen. Wenn die Trägerfolie im Bereich der Anschlussfahne mit einer Stanzung beziehungsweise Schlitzung S3 und S4 versehen ist, kann die Anschlussfahne an ihrer Unterseite durch den ausgestanzten Teil der Trägerfolie abgedeckt sein.

Die Aussparung 210 in der Folienlage 200 kann entfallen, wenn die Kontaktierung beispielsweise durch Krimpen oder durch berührungslose elektrische Anbindung, zum Beispiel durch Induktion, erfolgt. Die Aussparung 210 in der Folienlage 200 kann entweder vor dem Auflaminieren durch Stanzen eines Loches und Entfernen des Restmaterials eingebracht werden. Die Aussparung kann auch nach dem Auflaminieren eingebracht werden, wenn hierzu der Bereich der Aussparung unter Verwendung von lokal differenzierten Klebekräften bereitgestellt wird oder eine Klebekraft-Differenzierung durch eine gedruckte Klebstoffabdeckung erzeugt wird. Ergänzend oder alternativ zum Einbringen einer Aussparung kann die Folienlage 200 im Bereich der Kontaktierung schmäler ausgeführt werden, sodass bestimmte leitfähige Strukturteile für die Kontaktierung frei bleiben.

Das Einbringen von Konturen in den einzelnen Folienlagen kann neben dem Stanzen alternativ durch andere Trennverfahren, beispielsweise durch Plotterschneiden, Laserschneiden oder Wasserstrahlschneiden, erfolgen.

Neben den in den Figuren 1 und 5 gezeigten Folienverbünden kann ein einfacher Folienverbund mit elektrischer Funktionalität zum Aufbringen auf ein Substrat wie in Figur 1 dargestellt jedoch ohne die Verbindungsschicht 20 und die Folienlage 200 ausgebildet sein. Der Folienverbund weist bei dieser Ausführungsform lediglich die mindestens eine leitfähige Struktur mit der unterseitig angeordneten Verbindungsschicht 10, die auf der Trägerfolie 400 haftet, auf. Zum Aufbringen der mindestens einen leitfähigen Struktur kann die mindestens eine leitfähige Struktur 110 von der Trägerfolie 400 abgezogen und auf ein Substrat transferiert werden. Die mindestens eine leitfähige Struktur 110 haftete mittels der Verbindungsschicht 10 auf dem Substrat.

Der vereinfachte Folienaufbau sowie der in Figur 1 gezeigte Folienaufbau aus der Verbindungsschicht 10, dem optional an der Verbindungsschicht 10 haftenden Abschnitt der Trägerfolie 400, der mindestens einen leitfähigen Struktur 110, der Verbindungsschicht 20 und der Folienlage 200 beziehungsweise der in Figur 5 gezeigte Folienaufbau aus der Verbindungsschicht 30, dem optional an der Verbindungsschicht 30 haftenden Abschnitt der Trägerfolie 400, der Verbindungsschicht 10, der mindestens einen leitfähigen Struktur 110, der Verbindungsschicht 20 und der Folienlage 200 können auch in einer Stapelanordnung auf der Trägerfolie 400 angeordnet sein. Bei dieser Ausführungsform entsteht auf der Trägerfolie ein Multilagenaufbau aus mehreren Folienaufbauten mit mindestens einer leitfähigen Struktur. Die einzelnen leitfähigen Strukturen können für verschiedene Anwendungen eingesetzt und unterschiedlich angebunden werden.

### Bezugszeichenliste

- 10, 20, 30: Verbindungsschicht
- 100: elektrisch leitfähige Folie
- 110: leifähige Struktur
- 200,300: Folienlage
- 400: Trägerfolie
- 1000, 2000: Folienverbund mit elektrischer Funktionalität
- A: Stanzeinrichtung
- B: Kaschiereinrichtung
- C: Kaschiereinrichtung
- D: Stanzeinrichtung
- E: Kaschiereinrichtung
- G: Stanzeinrichtung
- S1,S2,S3,S4: Schnittlinien

## Patentansprüche

1. Folienverbund mit elektrischer Funktionalität zum Aufbringen auf ein Substrat, umfassend:
- mindestens eine leitfähige Struktur (110),
- eine erste Verbindungsschicht (10),
- eine Folienlage (200),
- eine zweite Verbindungsschicht (20),
- eine Trägerfolie (400), auf der die mindestens eine leitfähige Struktur (110) und die Folienlage (200) angeordnet sind,
- wobei die erste Verbindungsschicht (10) an einer Unterseite der mindestens einen leitfähigen Struktur (110) angeordnet ist,
- wobei die erste Verbindungsschicht (10) eine Haftwirkung zum Aufbringen der mindestens eine leitfähige Struktur (110) an dem Substrat aufweist,
- wobei die zweite Verbindungsschicht (20) zwischen einer Oberseite der mindestens einen leitfähigen Struktur (110) und der Folienlage (200) angeordnet ist,
- wobei die zweite Verbindungsschicht (20) eine Haftwirkung, durch die die Folienlage (200) an der mindestens einen leitfähigen Struktur (110) haftet, aufweist,
- wobei die mindestens eine leitfähige Struktur (110) und die darüber angeordnete Folienlage (200) zum Aufbringen auf das Substrat (3000) zumindest teilweise von der Trägerfolie (400) abziehbar sind.

2. Folienverbund nach Anspruch 1,
wobei die Folienlage (200) und die zweite Verbindungsschicht (20) jeweils einen Bereich (T200c, T20c), der sich über die mindestens eine leitfähige Struktur (110) hinaus erstreckt, aufweisen.

3. Folienverbund nach Anspruch 2, umfassend:
- eine weitere Folienlage (300),
- wobei die weitere Folienlage (300) mit ihrer Oberseite an der ersten Verbindungsschicht (10) und an dem sich über die mindestens eine leitfähige Struktur (110) hinaus erstreckenden Bereich (T20c) der zweiten Verbindungsschicht (20) haftet.

4. Folienverbund nach Anspruch 2, umfassend:
- wobei der sich über die mindestens eine leitfähige Struktur (110) hinaus erstreckende Bereich (T20c) der zweiten Verbindungsschicht (20) an der Trägerfolie (400) haftet,
- wobei die erste Verbindungsschicht (10) an der Trägerfolie (400) haftet.

5. Folienverbund nach Anspruch 4,
- wobei der Folienverbund (1000) auf das Substrat (3000) aufklebbar ist,
- wobei der Folienverbund derart ausgebildet ist, dass im auf dem Substrat aufgeklebten Zustand des Folienverbundes ein jeweiliger erster Teil (T110a, T200a) der mindestens einen leitfähigen Struktur (110) und der Folienlage (200) auf der Trägerfolie (400) und die Trägerfolie (400) unmittelbar auf dem Substrat (3000) angeordnet ist und ein zweiter Teil (T110b) der mindestens einen leitfähigen Struktur (110) mittels der ersten Verbindungsschicht (10) auf dem Substrat (3000) haftet und ein zweiter Teil (T200b) der Folienlage (200) mittels der zweiten Verbindungsschicht (20) auf dem zweiten Teil (110b) der mindestens einen leitfähigen Struktur (110) haftet und ein dritter Teil (T200c) der Folienlage (200) mittels der zweiten Verbindungsschicht (20) auf dem Substrat (3000) haftet.

6. Folienverbund nach Anspruch 3, umfassend:
- eine dritte Verbindungsschicht (30),
- wobei die dritte Verbindungsschicht (30) zwischen der weiteren Folienlage (300) und der Trägerfolie (400) angeordnet ist,
- wobei die dritte Verbindungsschicht (30) eine Haftwirkung, durch die die weitere Folienlage (300) auf der Trägerfolie (400) haftet, aufweist.

7. Folienverbund nach Anspruch 6,
- wobei der Folienverbund (2000) auf das Substrat (3000) aufklebbar ist,
- wobei der Folienverbund derart ausgebildet ist, dass im auf dem Substrat aufgeklebten Zustand des Folienverbundes ein jeweiliger erster Teil (T110a, T200a, T300a) der mindestens einen leitfähigen Struktur (110), der Folienlage (200) und der weiteren Folienlage (300) auf der Trägerfolie (400) angeordnet ist und die Trägerfolie (400) unmittelbar auf dem Substrat (3000) angeordnet ist und ein zweiter Teil (T300b) der weiteren Folienlage (300) mittels der dritten Verbindungsschicht (30) auf dem Substrat (3000) haftet.

8. Folienverbund nach einem der Ansprüche 3 bis 7,
wobei die Trägerfolie (400) mindestens eine Schnittlinie (S3, S4) die die Trägerfolie (400) durchtrennt, aufweist.

9. Folienverbund nach einem der Ansprüche 1 bis 8,
- wobei ein erster Abschnitt (A110a) der mindestens einen leitfähigen Struktur (110) von der Folienlage (200) bedeckt ist,
- wobei ein zweiter Abschnitt (A110b) der mindestens einen leitfähigen Struktur (110) von der Folienlage (200) unbedeckt ist.

10. Verfahren zum Herstellen eines Folienverbundes mit einer elektrisch leitfähigen Struktur, umfassend:
- Bereitstellen einer Trägerfolie (400),
- Anordnen einer elektrisch leitfähigen Folie (100) auf der Trägerfolie (400),
- Einbringen von mindestens einer ersten Schnittlinie (S1) in einen Bereich (B100) der elektrisch leitfähigen Folie (100) derart, dass die elektrisch leitfähigen Folie (100) durch die mindestens eine erste Schnittlinie (S1) an dem Bereich (B100) der elektrisch leitfähigen Folie (100) durchtrennt wird und ein erster unter dem Bereich der elektrisch leitfähigen Folie (100) angeordneter Bereich (B400a) der Trägerfolie (400) unversehrt bleibt, wodurch mindestens eine leitfähige Struktur (110) in der elektrisch leitfähigen Folie (100) gebildet wird, die durch die mindestens eine Schnittlinie (S1) von einem restlichen Teil der elektrisch leitfähigen Folie (100) getrennt ist,
- Entfernen des restlichen Teils der elektrisch leitfähigen Folie (100),
- Anordnen einer Folienlage (200) auf einer Oberseite der mindestens einen leitfähigen Struktur (110),
- Einbringen von mindestens einer zweiten Schnittlinie (S2) in einen Bereich (B200a) der Folienlage (200) derart, dass die Folienlage (200) durch die mindestens eine zweite Schnittlinie (S2) an dem Bereich (B200a) der Folienlage (200) durchtrennt wird und ein zweiter unter dem Bereich der Folienlage (200) angeordneter Bereich (B400b) der Trägerfolie (400) unversehrt bleibt, wobei die mindestens eine leitfähige Struktur (110) und die darüber angeordnete Folienlage (200) zum Aufbringen auf das Substrat (3000) zumindest teilweise von der Trägerfolie (400) abziehbar sind.

11. Verfahren nach Anspruch 10, umfassend:
- Einbringen von mindestens einer dritten Schnittlinie (S3) in einen dritten Bereich (B400c) der Trägerfolie (400) derart, dass die Trägerfolie (400) an dem dritten Bereich (B400c) der Trägerfolie durchschnitten wird,
- Einbringen von mindestens einer vierten Schnittlinie (S4) in einen zweiten Bereich (B200b) der Folienlage (200) und einen vierten unter dem zweiten Bereich der Folienlage (200) angeordneten Bereich (B400d) der Trägerfolie derart, dass die Folienlage (200) an dem zweiten Bereich (B200b) und die Trägerfolie (400) an dem vierten Bereich (B400d) durchtrennt werden, wobei sich die mindestens eine dritte und vierte Schnittlinie (S3, S4) derart überschneiden, dass ein aus der Trägerfolie (400) ausgeschnittener Bereich gebildet wird.

12. Verfahren nach einem der Ansprüche 10 und 11, umfassend:
- Bereitstellen einer ersten Verbindungsschicht (10) mit einer Haftwirkung und Aufbringen der ersten Verbindungsschicht (10) auf eine Unterseite der elektrisch leitfähigen Folie (100),
- Bereitstellen einer zweiten Verbindungsschicht (20) mit einer Haftwirkung und Aufbringen der zweiten Verbindungsschicht (20) auf eine Unterseite der Folienlage (200),
- Aufkaschieren der elektrisch leitfähigen Folie (100) mittels der ersten Verbindungsschicht (10) auf die Trägerfolie (400),
- Aufkaschieren der Folienlage (200) mittels der zweiten Verbindungsschicht (20) auf die mindestens eine leitfähige Struktur (110) und die Trägerfolie (400).

13. Verfahren nach Anspruch 10, umfassend:
- Bereitstellen einer ersten Verbindungsschicht (10) mit einer Haftwirkung und Aufbringen der ersten Verbindungsschicht (10) auf eine Unterseite der elektrisch leitfähigen Folie (100),
- Bereitstellen einer zweiten Verbindungsschicht (20) mit einer Haftwirkung und Aufbringen der zweiten Verbindungsschicht (20) auf eine Unterseite der Folienlage (200),
- Bereitstellen einer weiteren Folienlage (300),
- Bereitstellen einer dritten Verbindungsschicht (30) mit einer Haftwirkung und Aufbringen der dritten Verbindungsschicht (30) auf eine Unterseite der weiteren Folienlage (300),
- Aufkaschieren der weiteren Folienlage (300) mittels der dritten Verbindungsschicht (30) auf die Trägerfolie (400),
- Aufkaschieren der elektrisch leitfähigen Folie (100) mittels der ersten Verbindungsschicht (10) auf die weitere Folienlage (300),
- Einbringen der mindestens einen ersten Schnittlinie (S1) in den Bereich (B100) der elektrisch leitfähigen Folie (100) derart, dass ein erster unter dem Bereich (B100) der elektrisch leitfähigen Folie angeordneter Bereich (B300a) der weiteren Folienlage (300) unversehrt bleibt,
- Aufkaschieren der Folienlage (200) mittels der zweiten Verbindungsschicht (20) auf die mindestens eine leitfähige Struktur (110) und die weitere Folienlage (300),
- Einbringen der mindestens einen zweiten Schnittlinie (S2) in einen zweiten unter dem Bereich (B200a) der Folienlage (200) angeordneten Bereich (B300b) der weiteren Folienlage (300) derart, dass die weitere Folienlage (300) an dem zweiten Bereich (B300b) der weiteren Folienlage (300) mittels der mindestens einen zweiten Schnittlinie (S2) durchtrennt wird.

14. Verfahren nach Anspruch 13, umfassend:
- Einbringen von mindestens einer dritten Schnittlinie (S3) in einen dritten Bereich (B400c) der Trägerfolie (400) derart, dass die Trägerfolie an dem dritten Bereich (B400c) der Trägerfolie durchtrennt wird,
- Einbringen von mindestens einer vierten Schnittlinie (S4) in einen zweiten Bereich (B200b) der Folienlage (200) und einen dritten unter dem zweiten Bereich der Folienlage (200) angeordneten Bereich (B300c) der weiteren Folienlage (300) und einen vierten unter dem dritten Bereich der weiteren Folienlage (300) angeordneten Bereich (B400d) der Trägerfolie (400) derart, dass die Folienlage (200) an dem zweiten Bereich (B200b) und die weitere Folienlage (300) an dem dritten Bereich (B300c) und die Trägerfolie (400) an dem vierten Bereich (B400d) durchtrennt werden, wobei sich die mindestens eine dritte und vierte Schnittlinie (S3, S4) derart überschneiden, dass ein aus der Trägerfolie (400) ausgeschnittener Bereich gebildet wird.

15. Verfahren nach einem der Ansprüche 12 bis 14, umfassend:
Einbringen einer Aussparung (210) in die Folienlage (200) und die zweite Verbindungsschicht (20), bevor die Folienlage (200) auf die mindestens eine leitfähige Struktur (110) aufkaschiert wird.

## Claims

1. A foil composite having electric functionality and intended for being applied to a substrate, comprising:
- at least one conductive structure (110),
- a first connecting layer (10),
- a foil sheet (200),
- a second connecting layer (20),
- a carrier foil (400) on which the at least one conductive structure (110) and the foil sheet (200) are arranged,
- wherein the first connecting layer (10) is arranged on a lower side of the at least one conductive structure (110),
- wherein the first connecting layer (10) has an adhesive effect for applying the at least one conductive structure (110) to the substrate,
- wherein the second connecting layer (20) is arranged between an upper side of the at least one conductive structure (110) and the foil sheet (200),
- wherein the second connecting layer (20) has an adhesive effect by which the foil sheet (200) adheres to the at least one conductive structure (110),
- wherein the at least one conductive structure (110) and the superimposed foil sheet (200) for applying to the substrate (3000) can be peeled off from the carrier foil (400) at least in part.

2. The foil composite according to claim 1,
wherein the foil sheet (200) and the second connecting layer (20) each comprise an area (T200c, T20c) which extends beyond the at least one conductive structure (110).

3. The foil composite according to claim 2, comprising:
- a further foil sheet (300),
- wherein the further foil sheet (300) has its upper side adhered to the first connecting layer (10) and to the area (T20c) of the second connecting layer (20) extending beyond the at least one conductive structure (110).

4. The foil composite according to claim 2, comprising:
- wherein the area (T20c) of the second connecting layer (20) extending beyond the at least one conductive structure (110) adheres to the carrier foil (400),
- wherein the first connecting layer (10) adheres to the carrier foil (400).

5. The foil composite according to claim 4,
- wherein the foil composite (1000) can be glued to the substrate (3000),
- wherein the foil composite is formed such that in the state when the foil composite is glued to the substrate, a respective first part (T110a, T200a) of the at least one conductive structure (110) and of the foil sheet (200) is arranged on the carrier foil (400), and the carrier foil (400) is directly arranged on the substrate (3000) and a second part (T110b) of the at least one conductive structure (110) adheres to the substrate (3000) by means of the first connecting layer (10) and a second part (T200b) of the foil sheet (200) adheres to the second part (110b) of the at least one conductive structure (110) by means of the second connecting layer (20) and a third part (T200c) of the foil sheet (200) adheres to the substrate (3000) by means of the second connecting layer (20).

6. The foil composite according to claim 3, comprising:
- a third connecting layer (30),
- wherein the third connecting layer (30) is arranged between the further foil sheet (300) and the carrier foil (400),
- wherein the third connecting layer (30) has an adhesive effect by which the further foil sheet (300) adheres to the carrier foil (400).

7. The foil composite according to claim 6,
- wherein the foil composite (2000) can be glued to the substrate (3000),
- wherein the foil composite is formed such that in the state when the foil composite is glued to the substrate, a respective first part (T110a, T200a, T300a) of the at least one conductive structure (110), of the foil sheet (200) and of the further foil sheet (300) is arranged on the carrier foil (400), and the carrier foil (400) is directly arranged on the substrate (3000) and a second part (T300b) of the further foil sheet (300) adheres to the substrate (3000) by means of the third connecting layer (30).

8. The foil composite according to any of claims 3 to 7,
wherein the carrier foil (400) comprises at least one cutting line (S3, S4) which severs the carrier foil (400).

9. The foil composite according to any of claims 1 to 8,
- wherein a first portion (A110a) of the at least one conductive structure (110) is covered by the foil sheet (200),
- wherein a second portion (A110b) of the at least one conductive structure (110) is not covered by the foil sheet (200) .

10. A method for producing a foil composite having an electrically conductive structure, comprising:
- providing a carrier foil (400),
- arranging an electrically conductive foil (100) on the carrier foil (400),
- introducing at least a first cutting line (S1) in an area (B100) of the electrically conductive foil (100) in such a manner that the electrically conductive foil (100) is severed by the at least one first cutting line (S1) in the area (B100) of the electrically conductive foil (100), and a first area (B400a) of the carrier foil (400) arranged underneath the area of the electrically conductive foil (100) remains intact, whereby at least one conductive structure (110) is formed in the electrically conductive foil (100), which is separated by the at least one cutting line (S1) from a remaining part of the electrically conductive foil (100),
- removing the remaining part of the electrically conductive foil (100),
- arranging a foil sheet (200) on an upper side of the at least one conductive structure (110),
- introducing at least a second cutting line (S2) in an area (B200a) of the foil sheet (200) in such a manner that the foil sheet (200) is severed by the at least one second cutting line (S2) it the area (B200a) of the foil sheet (200) and a second area (B400b) of the carrier foil (400) arranged underneath the area of the foil sheet (200) remains intact, wherein the at least one conductive structure (110) and the superimposed foil sheet (200) for applying to the substrate (3000) can be peeled off from the carrier foil (400) at least in part.

11. The method according to claim 10, comprising:
- introducing at least a third cutting line (S3) in a third area (B400c) of the carrier foil (400) in such a manner that the carrier foil (400) is severed in the third area (B400c) of the carrier foil,
- introducing at least a fourth cutting line (S4) in a second area (B200b) of the foil sheet (200) and in a fourth area (B400d) of the carrier foil arranged underneath the second area of the foil sheet (200) in such a manner that the foil sheet (200) is severed in the second area (B200b) and the carrier foil (400) is severed in the fourth area (B400d), wherein the at least one third and fourth cutting lines (S3, S4) intersect such that an area is formed which is cut out from the carrier foil (400).

12. The method according to any of claims 10 and 11, comprising:
- providing a first connecting layer (10) having an adhesive effect and applying the first connecting layer (10) to a lower side of the electrically conductive foil (100),
- providing a second connecting layer (20) having an adhesive effect and applying the second connecting layer (20) to a lower side of the foil sheet (200),
- laminating the electrically conductive foil (100) by means of the first connecting layer (10) on the carrier foil (400),
- laminating the foil sheet (200) by means of the second connecting layer (20) on the at least one conductive structure (110) and the carrier foil (400).

13. The method according to claim 10, comprising:
- providing a first connecting layer (10) having an adhesive effect and applying the first connecting layer (10) to a lower side of the electrically conductive foil (100),
- providing a second connecting layer (20) having an adhesive effect and applying the second connecting layer (20) to a lower side of the foil sheet (200),
- providing a further foil sheet (300),
- providing a third connecting layer (30) having an adhesive effect and applying the third connecting layer (30) to a lower side of the further foil sheet (300),
- laminating the further foil sheet (300) by means of the third connecting layer (30) on the carrier foil (400),
- laminating the electrically conductive foil (100) by means of the first connecting layer (10) on the further foil sheet (300),
- introducing the at least one first cutting line (S1) in the area (B100) of the electrically conductive foil (100) in such a manner that a first area (B300a) of the further foil sheet (300) arranged underneath the area (B100) of the electrically conductive foil remains intact,
- laminating the foil sheet (200) by means of the second connecting layer (20) on the at least one conductive structure (110) and the further foil sheet (300),
- introducing the at least one second cutting line (S2) in a second area (B300b) of the further foil sheet (300) arranged underneath the area (B200a) of the foil sheet (200) in such a manner that the further foil sheet (300) is severed in the second area (B300b) of the further foil sheet (300) by means of the at least one second cutting line (S2).

14. The method according to claim 13, comprising:
- introducing at least a third cutting line (S3) in a third area (B400c) of the carrier foil (400) in such a manner that the carrier foil is severed in the third area (B400c) of the carrier foil,
- introducing at least a fourth cutting line (S4) in a second area (B200b) of the foil sheet (200) and in a third area (B300c) of the further foil sheet (300) arranged underneath the second area of the foil sheet (200) and in a fourth area (B400d) of the carrier foil (400) arranged underneath the third area of the further foil sheet (300) in such a manner that the foil sheet (200) is severed in the second area (B200b) and the further foil sheet (300) is severed in the third area (B300c) and the carrier foil (400) is severed in the fourth area (B400d), wherein the at least one third and fourth cutting lines (S3, S4) intersect such that an area is formed which is cut out from the carrier foil (400) .

15. The method according to any of claims 12 to 14, comprising:
introducing a recess (210) in the foil sheet (200) and the second connecting layer (20) prior to laminating the foil sheet (200) on the at least one conductive structure (110).

## Revendications

1. Composite de feuilles à fonctionnalité électrique pour l'apposition sur un substrat, comprenant :
- au moins une structure conductrice (110),
- une première couche de liaison (10),
- une nappe de feuilles (200),
- une deuxième couche de liaison (20),
- une feuille support (400) sur laquelle l'au moins une structure conductrice (110) et la nappe de feuilles (200) sont disposées,
- sachant que la première couche de liaison (10) est disposée sur une face inférieure de l'au moins une structure conductrice (110),
- sachant que la première couche de liaison (10) présente un effet d'adhérence pour l'apposition de l'au moins une structure conductrice (110) sur le substrat,
- sachant que la deuxième couche de liaison (20) est disposée entre une face supérieure de l'au moins une structure conductrice (110) et la nappe de feuilles (200),
- sachant que la deuxième couche de liaison (20) présente un effet d'adhérence par lequel la nappe de feuilles (200) adhère à l'au moins une structure conductrice (110),
- sachant que l'au moins une structure conductrice (110) et la nappe de feuilles (200) disposée au-dessus de celle-ci sont au moins en partie retirables de la feuille support (400) pour l'apposition sur le substrat (3000) .

2. Composite de feuilles selon la revendication 1,
sachant que la nappe de feuilles (200) et la deuxième couche de liaison (20) présentent respectivement une zone (T200c, T20c) qui s'étend au-delà de l'au moins une structure conductrice (110).

3. Composite de feuilles selon la revendication 2, comprenant :
- une nappe de feuilles supplémentaire (300),
- sachant que la nappe de feuilles supplémentaire (300) adhère par sa face supérieure à la première couche de liaison (10) et à la zone (T20c) de la deuxième couche de liaison (20) qui s'étend au-delà de l'au moins une structure conductrice (110).

4. Composite de feuilles selon la revendication 2,
- sachant que la zone (T20c) de la deuxième couche de liaison (20) qui s'étend au-delà de l'au moins une structure conductrice (110) adhère à la feuille support (400),
- sachant que la première couche de liaison (10) adhère à la feuille support (400).

5. Composite de feuilles selon la revendication 4,
- sachant que le composite de feuilles (1000) est collable sur le substrat (3000),
- sachant que le composite de feuilles est constitué de telle façon que, dans l'état où le composite de feuilles est collé sur le substrat, une première partie (T110a, T200a) respective de l'au moins une structure conductrice (110) et de la nappe de feuilles (200) est disposée sur la feuille support (400) et la feuille support (400) est disposée directement sur le substrat (3000) et une deuxième partie (T110b) de l'au moins une structure conductrice (110) adhère sur le substrat (3000) moyennant la première couche de liaison (10) et une deuxième partie (T200b) de la nappe de feuilles (200) adhère sur la deuxième partie (T110b) de l'au moins une structure conductrice (110) moyennant la deuxième couche de liaison (20) et une troisième partie (T200c) de la nappe de feuilles (200) adhère sur le substrat (3000) moyennant la deuxième couche de liaison (20) .

6. Composite de feuilles selon la revendication 3, comprenant :
- une troisième couche de liaison (30),
- sachant que la troisième couche de liaison (30) est disposée entre la nappe de feuilles supplémentaire (300) et la feuille support (400),
- sachant que la troisième couche de liaison (30) présente un effet d'adhérence par lequel la nappe de feuilles supplémentaire (300) adhère sur la feuille support (400) .

7. Composite de feuilles selon la revendication 6,
- sachant que le composite de feuilles (2000) est collable sur le substrat (3000),
- sachant que le composite de feuilles est constitué de telle façon que, dans l'état où le composite de feuilles est collé sur le substrat, une première partie (T110a, T200a, T300a) respective de l'au moins une structure conductrice (110), de la nappe de feuilles (200) et de la nappe de feuilles supplémentaire (300) est disposée sur la feuille support (400) et la feuille support (400) est disposée directement sur le substrat (3000) et une deuxième partie (T300b) de la nappe de feuilles supplémentaire (300) adhère sur le substrat (3000) moyennant la troisième couche de liaison (30).

8. Composite de feuilles selon l'une des revendications 3 à 7,
sachant que la feuille support (400) présente au moins une ligne de coupe (S3, S4) qui sectionne la feuille support (400) .

9. Composite de feuilles selon l'une des revendications 1 à 8,
- sachant qu'une première section (A110a) de l'au moins une structure conductrice (110) est recouverte par la nappe de feuilles (200),
- sachant qu'une deuxième section (A110b) de l'au moins une structure conductrice (110) n'est pas recouverte par la nappe de feuilles (200).

10. Procédé de fabrication d'un composite de feuilles comportant une structure électriquement conductrice, comprenant :
- la mise à disposition d'une feuille support (400),
- la disposition d'une feuille électriquement conductrice (100) sur la feuille support (400),
- la création d'au moins une première ligne de coupe (S1) dans une zone (B100) de la feuille électriquement conductrice (100) de telle façon que la feuille électriquement conductrice (100) soit sectionnée par l'au moins une première ligne de coupe (S1) au niveau de la zone (B100) de la feuille électriquement conductrice (100) et une première zone (B400a) de la feuille support (400) disposée sous la zone de la feuille électriquement conductrice (100) reste intacte, ce par quoi au moins une structure conductrice (110) qui est séparée d'une partie restante de la feuille électriquement conductrice (100) par l'au moins une ligne de coupe (S1) est formée dans la feuille électriquement conductrice (100),
- l'enlèvement de la partie restante de la feuille électriquement conductrice (100),
- la disposition d'une nappe de feuilles (200) sur une face supérieure de l'au moins une structure conductrice (110),
- la création d'au moins une deuxième ligne de coupe (S2) dans une zone (B200a) de la nappe de feuilles (200) de telle façon que la nappe de feuilles (200) soit sectionnée par l'au moins une deuxième ligne de coupe (S2) au niveau de la zone (B200a) de la nappe de feuilles (200) et une deuxième zone (B400b) de la feuille support (400) disposée sous la zone de la nappe de feuilles (200) reste intacte, sachant que l'au moins une structure conductrice (110) et la nappe de feuilles (200) disposée au-dessus de celle-ci sont retirables au moins en partie de la feuille support (400) pour l'apposition sur le substrat (3000).

11. Procédé selon la revendication 10, comprenant :
- la création d'au moins une troisième ligne de coupe (S3) dans une troisième zone (B400c) de la feuille support (400) de telle façon que la feuille support (400) soit sectionnée au niveau de la troisième zone (B400c) de la feuille support,
- la création d'au moins une quatrième ligne de coupe (S4) dans une deuxième zone (B200b) de la nappe de feuilles (200) et une quatrième zone (B400d) de la feuille support disposée sous la deuxième zone de la nappe de feuilles (200) de telle façon que la nappe de feuilles (200) soit sectionnée au niveau de la deuxième zone (B200b) et la feuille support (400) au niveau de la quatrième zone (B400d), sachant que l'au moins une troisième et quatrième ligne de coupe (S3, S4) se recoupent de telle façon qu'une zone découpée à partir de la feuille support (400) soit formée.

12. Procédé selon l'une des revendications 10 et 11, comprenant :
- la mise à disposition d'une première couche de liaison (10) avec un effet d'adhérence et l'apposition de la première couche de liaison (10) sur une face inférieure de la feuille électriquement conductrice (100),
- la mise à disposition d'une deuxième couche de liaison (20) avec un effet d'adhérence et l'apposition de la deuxième couche de liaison (20) sur une face inférieure de la nappe de feuilles (200),
- le laminage de la feuille électriquement conductrice (100) sur la feuille support (400) moyennant la première couche de liaison (10),
- le laminage de la nappe de feuilles (200) sur l'au moins une structure conductrice (110) et la feuille support (400) moyennant la deuxième couche de liaison (20).

13. Procédé selon la revendication 10, comprenant :
- la mise à disposition d'une première couche de liaison (10) avec un effet d'adhérence et l'apposition de la première couche de liaison (10) sur une face inférieure de la feuille électriquement conductrice (100),
- la mise à disposition d'une deuxième couche de liaison (20) avec un effet d'adhérence et l'apposition de la deuxième couche de liaison (20) sur une face inférieure de la nappe de feuilles (200),
- la mise à disposition d'une nappe de feuilles supplémentaire (300),
- la mise à disposition d'une troisième couche de liaison (30) avec un effet d'adhérence et l'apposition de la troisième couche de liaison (30) sur une face inférieure de la nappe de feuilles supplémentaire (300),
- le laminage de la nappe de feuilles supplémentaire (300) sur la feuille support (400) moyennant la troisième couche de liaison (30),
- le laminage de la feuille électriquement conductrice (100) sur la nappe de feuilles supplémentaire (300) moyennant la première couche de liaison (10),
- la création de l'au moins une première ligne de coupe (S1) dans la zone (B100) de la feuille électriquement conductrice (100) de telle façon qu'une première zone (B300a) de la nappe de feuilles supplémentaire (300) disposée sous la zone (B100) de la feuille électriquement conductrice reste intacte,
- le laminage de la nappe de feuilles (200) sur l'au moins une structure conductrice (110) et la nappe de feuilles supplémentaire (300) moyennant la deuxième couche de liaison (20),
- la création de l'au moins une deuxième ligne de coupe (S2) dans une deuxième zone (B300b) de la nappe de feuilles supplémentaire (300) disposée sous la zone (B200a) de la nappe de feuilles (200) de telle façon que la nappe de feuilles supplémentaire (300) soit sectionnée au niveau de la deuxième zone (B300b) de la nappe de feuilles supplémentaire (300) moyennant l'au moins une deuxième ligne de coupe (S2).

14. Procédé selon la revendication 13, comprenant :
- la création d'au moins une troisième ligne de coupe (S3) dans une troisième zone (B400c) de la feuille support (400) de telle façon que la feuille support soit sectionnée au niveau de la troisième zone (B400c) de la feuille support,
- la création d'au moins une quatrième ligne de coupe (S4) dans une deuxième zone (B200b) de la nappe de feuilles (200) et une troisième zone (B300c) de la nappe de feuilles supplémentaire (300) disposée sous la deuxième zone de la nappe de feuilles (200) et une quatrième zone (B400d) de la feuille support (400) disposée sous la troisième zone de la nappe de feuilles supplémentaire (300) de telle façon que la nappe de feuilles (200) soit sectionnée au niveau de la deuxième zone (B200b) et la nappe de feuilles supplémentaire (300) au niveau de la troisième zone (B300c) et la feuille support (400) au niveau de la quatrième zone (B400d), sachant que l'au moins une troisième et quatrième ligne de coupe (S3, S4) se recoupent de telle façon qu'une zone découpée à partir de la feuille support (400) soit formée.

15. Procédé selon l'une des revendications 12 à 14, comprenant :
la création d'un évidement (210) dans la nappe de feuilles (200) et la deuxième couche de liaison (20) avant que la nappe de feuilles (200) soit laminée sur l'au moins une structure conductrice (110).
